(19) Europäisches Patentamt
European Patent Office
Office européen des brevets

(11) **EP 4 737 925 A1**

(12) **EUROPEAN PATENT APPLICATION**
published in accordance with Art. 153(4) EPC

(43) Date of publication:
06.05.2026 Bulletin 2026/19

(21) Application number: 24877406.9

(22) Date of filing: 02.09.2024

(51) International Patent Classification (IPC):
$G01R\ 31/392^{(2019.01)}$    $G01R\ 31/382^{(2019.01)}$
$G01R\ 31/385^{(2019.01)}$    $G01R\ 31/396^{(2019.01)}$
$G01R\ 19/165^{(2006.01)}$    $B60L\ 58/16^{(2019.01)}$
$H01M\ 10/0525^{(2010.01)}$    $H01M\ 10/48^{(2006.01)}$

(52) Cooperative Patent Classification (CPC):
B60L 58/16; G01R 19/165; G01R 31/382;
G01R 31/385; G01R 31/392; G01R 31/396;
H01M 10/0525; H01M 10/48; Y02E 60/10

(86) International application number:
PCT/KR2024/013167

(87) International publication number:
WO 2025/079867 (17.04.2025 Gazette 2025/16)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 13.10.2023 KR 20230136849

(71) Applicant: LG Energy Solution, Ltd.
Seoul 07335 (KR)

(72) Inventors:
• SONG, Hee-Seok
Daejeon 34122 (KR)
• KIM, Yong-Jun
Daejeon 34122 (KR)
• BAE, Yoon-Jung
Daejeon 34122 (KR)

(74) Representative: Goddar, Heinz J.
Boehmert & Boehmert
Anwaltspartnerschaft mbB
Pettenkoferstrasse 22
80336 München (DE)

(54) **BATTERY DIAGNOSTIC DEVICE AND METHOD**

(57) An apparatus for diagnosing a battery according to the present disclosure includes a capacity calculating unit configured to calculate a positive electrode capacity value and a negative electrode capacity value of the battery, respectively, for each predetermined number of charge and discharge cycles; a degradation rate calculating unit configured to calculate a positive electrode degradation rate and a negative electrode degradation rate of the battery, respectively, based on the positive electrode capacity values and the negative electrode capacity values calculated by the capacity calculating unit; and a diagnosing unit configured to diagnose a state of the battery by referring to a comparison result of comparing the positive electrode degradation rate and the negative electrode degradation rate.

FIG. 1

**Description**

TECHNICAL FIELD

This application is based on and claims priority from Korean Patent Application No. 10-2023-0136849, filed on October 13, 2023, with the Korean Intellectual Property Office, the disclosure of which is incorporated herein in its entirety by reference.

The present disclosure relates to an apparatus and method for diagnosing a battery, and more particularly, to an apparatus and method for diagnosing a state of a battery capable of repeated charging and discharging.

BACKGROUND ART

Recently, the demand for portable electronic products such as notebook computers, digital cameras and portable telephones has increased sharply, and electric vehicles, energy storage systems, robots, satellites and the like have been developed in earnest. Accordingly, high-performance batteries allowing repeated charging and discharging are being actively studied.

Types of rechargeable batteries include lithium batteries that use lithium ions, such as lithium-ion batteries or lithium-ion polymer batteries, and nickel cadmium batteries, nickel hydrogen batteries, and nickel zinc batteries. Among these, lithium batteries have the advantages of having a relatively long lifespan, a very low self-discharge rate, and high energy density because they have almost no memory effect compared to batteries that use nickel, and thus their application range is gradually expanding.

Meanwhile, the positive electrode and negative electrode of such a battery gradually degrade as the number of charge and discharge cycles of the battery increases, resulting in a decrease in electrical capacity. In this case, the positive electrode and negative electrode may degrade at different rates. The difference in degradation rate between the positive electrode and negative electrode may result in rapid performance degradation, shortened lifespan, or damage to the separator of the battery.

For example, in the case of a lithium battery, if the degradation rate of the negative electrode is faster than the degradation rate of the positive electrode so that the capacity of the negative electrode decreases below the capacity of the positive electrode, the lithium ions of the positive electrode are converted into lithium metal through a side reaction with the electrolyte and deposited on the surface of the negative electrode, which causes a lithium plating phenomenon. This lithium plating phenomenon further reduces the capacity of the negative electrode, shortens the life of the battery, and may damage the separator between the positive electrode and the negative electrode, resulting in battery failure or thermal runaway.

Therefore, a battery diagnostic technology is required that may accurately determine the point in time when a change in charge and discharge condition applied to the battery is required by monitoring the battery degradation rate for each electrode.

However, as disclosed in Japanese Patent Laid-Open Publication No. 2009-252381, since the existing technology determines the degradation state of a battery on a battery-by-battery basis through differential voltage analysis, there is a problem in that the degradation rate of each electrode of the battery cannot be confirmed, and as a result, the point in time when a change in charge and discharge condition applied to the battery is required cannot be accurately determined.

DISCLOSURE

Technical Problem

The technical challenge that the present disclosure seeks to solve is to provide an apparatus and method for diagnosing a battery that may prevent performance degradation and shortened lifespan of the battery by monitoring the degradation rate of the battery for each electrode.

Another technical challenge that the present disclosure seeks to solve is to provide an apparatus and method for diagnosing a battery that may extend the life of the battery while ensuring the safety of the battery.

Another technical challenge that the present disclosure seeks to solve is to provide a battery pack and a vehicle including the apparatus for diagnosing a battery according to the present disclosure.

Technical Solution

An apparatus for diagnosing a battery according to one aspect of the present disclosure diagnoses a state of a battery capable of repeated charging and discharging, and comprises a capacity calculating unit configured to calculate a positive electrode capacity value and a negative electrode capacity value of the battery, respectively, for each predetermined number of charge and discharge cycles; a degradation rate calculating unit configured to calculate a positive electrode degradation rate and a negative electrode degradation rate of the battery, respectively, based on the positive electrode capacity values and the negative electrode capacity values calculated by the capacity calculating unit; and a diagnosing unit configured to diagnose a state of the battery by referring to a comparison result of comparing the positive electrode degradation rate and the negative electrode degradation rate.

In an embodiment, the capacity calculating unit may be configured to generate a battery profile representing a correspondence relationship between capacity and voltage of the battery that changes while the battery is being charged or discharged, before calculating the positive electrode capacity value and the negative electrode capacity value, and to calculate the positive electrode capacity value and the negative electrode capacity value, respectively, based on the battery profile.

In an embodiment, the capacity calculating unit may be configured to generate a first differential profile representing a correspondence relationship between a differential capacity, which is obtained by differentiating the capacity of the battery with respect to the voltage of the battery, and the voltage of the battery, based on the battery profile, and to calculate the positive electrode capacity value using the first differential profile.

In an embodiment, the capacity calculating unit may be configured to select a partial section from an entire section of the first differential profile, calculate an area between a voltage axis representing the voltage of the first differential profile and the partial section, and calculate the positive electrode capacity value based on the calculated area.

In an embodiment, the capacity calculating unit may be configured to generate a second differential profile representing a correspondence relationship between a differential voltage, which is obtained by differentiating the voltage of the battery with respect to the capacity of the battery, and the capacity of the battery, based on the battery profile, and to calculate the negative electrode capacity value using the second differential profile.

In an embodiment, the capacity calculating unit may be configured to select two peaks among peaks appearing in the second differential profile according to a predetermined selection criterion, calculate a capacity difference between the two peaks, and calculate the negative electrode capacity value based on the calculated capacity difference.

In an embodiment, the degradation rate calculating unit may be configured to calculate the positive electrode degradation rate and the negative electrode degradation rate based on a positive electrode capacity decrease amount and a negative electrode capacity decrease amount of the battery that are generated at each charge and discharge cycle of the battery.

In an embodiment, the apparatus may further comprise a NP ratio calculating unit for calculating a NP ratio of the battery by using the positive electrode capacity value and the negative electrode capacity value of the battery calculated at a diagnosis point of the battery, and the diagnosing unit may be configured to determine the state of the battery by further referring to a comparison result of comparing the NP ratio with a predetermined reference NP ratio.

In an embodiment, the diagnosing unit may be configured to diagnose the state of the battery as a normal state that does not require a change in a charge condition or a discharge condition of the battery, when the NP ratio is not smaller than the reference NP ratio and the negative electrode degradation rate is not faster than the positive electrode degradation rate.

In an embodiment, the diagnosing unit may be configured to diagnose the state of the battery as a first abnormal state that requires a change in a charge condition or a discharge condition of the battery, when the NP ratio is not smaller than the reference NP ratio, but the negative electrode degradation rate is faster than the positive electrode degradation rate.

In an embodiment, the diagnosing unit may be configured to diagnose the state of the battery as a second abnormal state that requires discontinuation of use of the battery, when the NP ratio is smaller than the reference NP ratio.

In an embodiment, the diagnosing unit may be configured to diagnose the state of the battery as an abnormal state that requires a change in a charge condition or a discharge condition of the battery or discontinuation of use, when the negative electrode degradation rate is faster than the positive electrode degradation rate, and the apparatus may further comprise a charge and discharge adjusting unit configured to change the charge condition or the discharge condition of the battery or to stop charging and discharging of the battery, when the state of the battery is diagnosed as an abnormal state.

A battery pack according to another aspect of the present disclosure may comprise the apparatus for diagnosing a battery as described above.

A vehicle according to still another aspect of the present disclosure may comprise the apparatus for diagnosing a battery as described above.

A method for diagnosing a battery according to another aspect of the present disclosure diagnoses a state of a battery capable of repeated charging and discharging by using a processor, and comprises calculating a positive electrode capacity value and a negative electrode capacity value of the battery, respectively, for each predetermined number of charge and discharge cycles by the processor; a degradation rate calculating step of calculating a positive electrode degradation rate and a negative electrode degradation rate of the battery based on the positive electrode capacity values and the negative electrode capacity values calculated by the processor; and diagnosing a state of the battery by referring to a comparison result of comparing the positive electrode degradation rate and the negative electrode degradation rate by the processor.

Advantageous Effects

The apparatus for diagnosing a battery according to the present disclosure calculates a positive electrode capacity value and a negative electrode capacity value of the battery for each predetermined number of charge and discharge cycles, and calculates a positive electrode degradation rate and a negative electrode degradation rate of the battery based on the calculated positive electrode capacity values and the calculated negative electrode capacity values, thereby enabling the degradation rate of the battery to be monitored for each electrode, and the point in time when a change in the charge and discharge condition of the battery is required may be accurately determined by referring to the degradation rate of each electrode.

Also, in an embodiment, the apparatus for diagnosing a battery diagnoses the state of the battery by referring to the comparison result of comparing the positive electrode degradation rate and the negative electrode degradation rate of the battery, thereby facilitating charge and discharge management of the battery, which may cause rapid performance degradation, shortened lifespan, or separator damage when a difference in degradation rate occurs between the positive electrode and the negative electrode, and ensuring the safety of the battery.

Also, in an embodiment, the apparatus for diagnosing a battery diagnoses the state of the battery based on the NP ratio and the degradation rate of each electrode, thereby determining the point in time of a change in the charge condition or discharge condition applied to the battery, thereby improving the safety of the battery and extending the life of the battery.

Furthermore, a person having ordinary skill in the art to which the present disclosure belongs will be able to clearly understand from the following description that various embodiments according to the present disclosure can solve various technical problems not mentioned above.

## DESCRIPTION OF DRAWINGS

FIG. 1 is a block diagram showing an apparatus for diagnosing a battery according to an embodiment of the present disclosure.
FIG. 2 is a drawing showing a battery profile representing a correspondence relationship between capacity and voltage of a battery.
FIGS. 3 to 5 are drawings showing first differential profiles representing a correspondence relationship between the voltage and differential capacity of the battery in different charge and discharge cycles.
FIGS. 6 to 8 are drawings showing second differential profiles representing a correspondence relationship between the capacity and differential voltage of the battery in different charge and discharge cycles.
FIG. 9 is a drawing showing a first graph representing a trend of capacity decrease for each electrode of a battery with constant charge and discharge conditions.
FIG. 10 is a drawing showing a second graph representing a trend of capacity decrease for each electrode of a battery with changed charge and discharge conditions according to the present disclosure.
FIG. 11 is a flow chart showing a method for diagnosing a battery according to an embodiment of the present disclosure.
FIG. 12 is a drawing showing a battery pack according to an embodiment of the present disclosure.
FIG. 13 is a drawing showing a vehicle according to an embodiment of the present disclosure.

## BEST MODE

Hereinafter, in order to clarify the solution corresponding to the technical challenge of the present disclosure, embodiments according to the present disclosure will be described in detail with reference to the attached drawings. However, when explaining the present disclosure, if a description of a related publicly known technology obscures the gist of the present disclosure, the description thereof may be omitted.

In addition, the terms used in this specification are terms defined in consideration of the functions in the present disclosure, and these may vary depending on the intention or custom of the designer, manufacturer, etc. Therefore, the definitions of the terms described below should be made based on the contents throughout this specification.

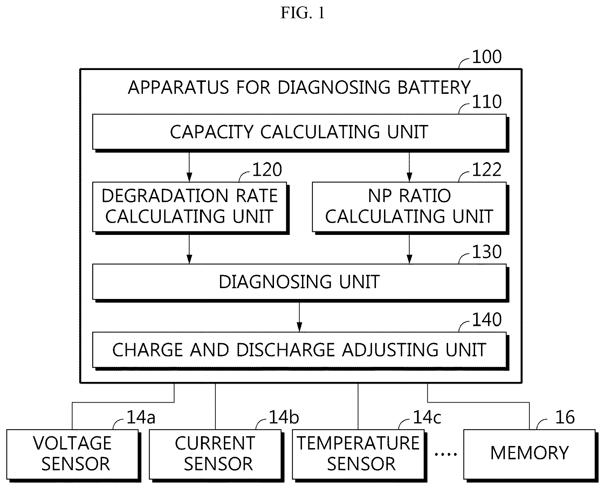

FIG. 1 is a block diagram showing an apparatus 100 for diagnosing a battery according to an embodiment of the present disclosure.

As illustrated in FIG. 1, the apparatus 100 for diagnosing a battery according to an embodiment of the present disclosure is a device configured to diagnose the state of a battery capable of repeated charging and discharging, and includes a capacity calculating unit 110, a degradation rate calculating unit 120, and a diagnosing unit 130.

The battery to be diagnosed in the apparatus 100 for diagnosing a battery according to the present disclosure (hereinafter, "target battery") may be a battery cell corresponding to a basic unit of charge and discharge, a battery module in which a plurality of battery cells are connected in series and/or in parallel, or a battery pack in which a plurality of battery cells or a plurality of battery modules are connected in series and/or in parallel.

The capacity calculating unit 110 is configured to calculate a positive electrode capacity value and a negative electrode capacity value, which represent current capacities of the positive electrode and the negative electrode of the target battery, respectively, for each predetermined number of charge and discharge cycles of the target battery. As described again below, the capacity calculating unit 110 may be configured to generate a battery profile representing a correspondence relationship or correlation between capacity and voltage of the target battery that change while the target battery is being charged or discharged, before calculating the positive electrode capacity value and the negative electrode capacity value of the target battery, and to calculate the positive electrode capacity value and the negative electrode capacity value of the target battery, respectively, based on the battery profile.

The degradation rate calculating unit 120 is configured to calculate the positive electrode degradation rate and the negative electrode degradation rate of the target battery, respectively, based on the positive electrode capacity values and the negative electrode capacity values calculated by the capacity calculating unit 110. For example, the degradation rate calculating unit 120 may calculate the positive electrode degradation rate and the negative electrode degradation rate based on the positive electrode capacity decrease amount and the negative electrode capacity decrease amount of the target battery that are generated at each charge and discharge cycle of the target battery.

The diagnosing unit 130 is configured to diagnose the state of the target battery by referring to the comparison result of comparing the positive electrode degradation rate and the negative electrode degradation rate. For example, if the negative electrode degradation rate is faster than the positive electrode degradation rate, the diagnosing unit 130 may diagnose the state of the target battery as an abnormal state that requires a change in the charge condition or discharge condition of the target battery or discontinuation of use.

In an embodiment, the apparatus 100 for diagnosing a battery according to the present disclosure may further include an NP ratio calculating unit 122. The NP ratio calculating unit 122 may be configured to calculate an NP ratio of the target battery corresponding to the diagnosis point by using the positive electrode capacity value and the negative electrode capacity value of the target battery calculated at the diagnosis point of the target battery. In this case, the NP ratio of the target battery may be calculated as in the formula 1.

[Formula 1]

$$Rt = (Cn / Cp) \times 100 \, [\%]$$

In the formula 1, Rt is the NP ratio of the target battery, Cn is the negative electrode capacity of the target battery, and Cp is the positive electrode capacity of the target battery.

In this case, the diagnosing unit 130 may be configured to determine the state of the target battery by further referring to the comparison result of comparing the NP ratio with a predetermined reference NP ratio.

In an embodiment, the reference NP ratio may be an NP ratio obtained by adding or subtracting a predetermined margin value to/from the NP ratio of the target battery calculated at the BOL (Beginning of Life) point of the target battery. In this case, the margin value may be determined in a range of 0 to 10 percentage points. In another embodiment, the reference NP ratio may be an NP ratio determined in advance according to the components and amounts of the positive electrode active material and the negative electrode active material of the target battery.

For example, if the NP ratio of the target battery corresponding to the diagnosis point is not smaller than the reference NP ratio and the negative electrode degradation rate of the target battery is not faster than the positive electrode degradation rate, the diagnosing unit 130 may diagnose the state of the target battery as a normal state that does not require a change in the charge condition or discharge condition of the target battery.

In contrast, if the NP ratio of the target battery corresponding to the diagnosis point is not smaller than the reference NP ratio, but the negative electrode degradation rate of the target battery is faster than the positive electrode degradation rate, the diagnosing unit 130 may diagnose the state of the target battery as a first abnormal state that requires a change in the charge condition or discharge condition of the target battery.

In particular, if the NP ratio of the target battery corresponding to the diagnosis point becomes smaller than the reference NP ratio as a result of the negative electrode degradation rate of the target battery becoming faster than the positive electrode degradation rate before the diagnosis point, the diagnosing unit 130 may diagnose the state of the target battery as a second abnormal state that requires discontinuation of use of the battery.

In an embodiment, the apparatus 100 for diagnosing a battery according to the present disclosure may further include a charge and discharge adjusting unit 140. The charge and discharge adjusting unit 140 may be configured to change a charge condition or a discharge condition of the target battery, or to stop charging and discharging of the target battery, when the state of the target battery is diagnosed as an abnormal state.

That is, when the state of the target battery is diagnosed as the first abnormal state, the charge and discharge adjusting unit 140 may prevent rapid degradation of the target battery by changing the charge condition or discharge condition of the target battery. In an embodiment, the charge and discharge adjusting unit 140 may be configured to control a charger or a discharger to lower a current rate for charging or discharging the target battery, or to lower a full-charge voltage of the target battery. In another embodiment, the charge and discharge adjusting unit 140 may be configured to control a cooling device, such as a heat sink, to lower the temperature of the target battery.

The capacity calculating unit 110, the degradation rate calculating unit 120, and the diagnosing unit 130 of the apparatus 100 for diagnosing a battery described above may be implemented by a processor and a program executed through the processor. In addition, when the apparatus 100 for diagnosing a battery further includes the NP ratio calculating unit 122 and the charge and discharge adjusting unit 140 described above, the NP ratio calculating unit 122 and the charge and discharge adjusting unit 140 may be implemented by a processor and a program executed through the processor. The capacity calculating unit 110, the degradation rate calculating unit 120, the diagnosing unit 130, the NP ratio calculating unit 122, and the charge and discharge adjusting unit 140 may be implemented by a single processor, or by two or more processors that interact with each other.

In an embodiment, the apparatus 100 for diagnosing a battery according to the present disclosure may be configured to interact with various sensors, such as a voltage sensor 14a for sensing the voltage of the battery, a current sensor 14b for sensing the charge/discharge current of the battery, and a temperature sensor 14c for sensing the temperature of the battery.

In addition, the apparatus 100 for diagnosing a battery according to the present disclosure may be configured to interact with a memory 16 capable of storing a program or data necessary for battery diagnosis. In this case, the memory 16 may include one or more of various types of storage media such as RAM, ROM, EEPROM, flash memory, registers, etc.

In another embodiment, the apparatus for diagnosing a battery according to the present disclosure may be configured to include one or more of the voltage sensor 14a, the current sensor 14b, the temperature sensor 14c, and the memory 16 described above.

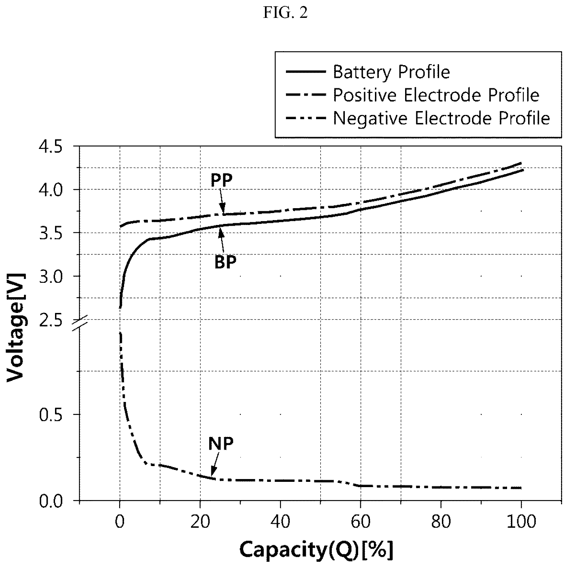

FIG. 2 is a drawing showing a battery profile BP representing a correspondence relationship between capacity and voltage of a battery.

As illustrated in FIG. 2, the apparatus 100 for diagnosing a battery according to an embodiment of the present disclosure may generate a battery profile BP representing a correspondence relationship or correlation between the capacity and voltage of the target battery that change while the target battery is being charged or discharged, before calculating the positive electrode capacity value and the negative electrode capacity value of the target battery.

To this end, the capacity calculating unit 110 may interact with the voltage sensor 14a for sensing the voltage of the target battery and the current sensor 14b for sensing the charge and discharge current of the target battery. That is, while the target battery is being charged or discharged, the capacity calculating unit 110 may measure the voltage of the target battery through the voltage sensor 14a sense the charge current or discharge current of the target battery through the current sensor 14b, and calculate the capacity of the target battery by applying the current integration method to the sensed current values. As a result, the capacity calculating unit 110 may generate a battery profile BP corresponding to the correspondence relationship between the capacity and voltage of the target battery.

In FIG. 2, % is used as a unit of capacity (Q), but Ah, which is the product of current and time, may also be used as a unit of capacity (Q).

In addition, the capacity calculating unit 110 may calculate the positive electrode capacity value and the negative electrode capacity value of the target battery based on the generated battery profile BP, respectively.

In an embodiment, the capacity calculating unit 110 may obtain the positive electrode profile PP and the negative electrode profile NP of the target battery from the battery profile BP of the target battery using a predetermined simulation program. For example, the capacity calculating unit 110 may obtain the positive electrode profile PP and the negative electrode profile NP through a simulation program that selects a positive electrode profile and a negative electrode profile that generate a profile identical to or most similar to the battery profile BP through a combination of various types of positive electrode profiles and negative electrode profiles.

In this case, the capacity calculating unit 110 may calculate the positive electrode capacity value and the negative electrode capacity value of the target battery at the diagnosis point based on the obtained positive electrode profile PP and negative electrode profile NP.

In another embodiment, the capacity calculating unit 110 may calculate the positive electrode capacity value and the negative electrode capacity value of the target battery based on the differential profile obtained by differentiating the battery profile BP with respect to voltage or capacity.

For example, the capacity calculating unit 110 may be configured to generate a first differential profile that represents a correspondence relationship or correlation between the differential capacity obtained by differentiating the capacity of the target battery with respect to the voltage of the target battery and the voltage of the target battery based on the battery profile BP, and to calculate the positive electrode capacity value of the target battery using this first differential profile.

In addition, the capacity calculating unit 110 may be configured to generate a second differential profile that represents a correspondence relationship or correlation between the differential voltage obtained by differentiating the voltage of the target battery with respect to the capacity of the target battery and the capacity of the target battery based on the battery profile BP, and to calculate the negative electrode capacity value of the target battery using this second differential profile.

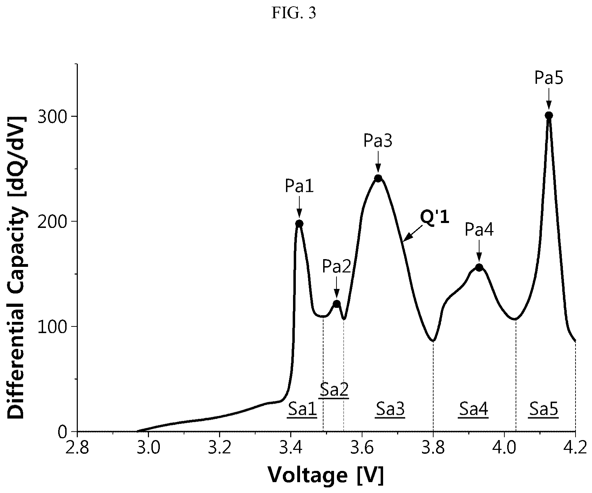

FIGS. 3 to 5 are drawings showing first differential profiles representing a correspondence relationship between the voltage and differential capacity of the battery in different charge and discharge cycles.

FIG. 3 shows the first differential profile (Q'1) corresponding to the BOL (Beginning Of Life) period of the target battery.

As illustrated in FIG. 3, the capacity calculating unit 110 may generate a first differential profile (Q'1) that represents a correspondence relationship between the differential capacity obtained by differentiating the capacity of the target battery with respect to the voltage of the target battery and the voltage of the target battery based on the battery profile BP generated at the BOL (Beginning Of Life) period of the target battery, and calculate the positive electrode capacity value of the target battery using this first differential profile (Q'1).

For example, the capacity calculating unit 110 may select a partial section from the entire section of the first differential profile (Q'1), calculate the area between the voltage axis (horizontal axis) representing the voltage of the first differential profile (Q'1) and the partial section, and calculate the positive electrode capacity value of the target battery based on the calculated area.

To this end, the capacity calculating unit 110 may select peak points Pa1 to Pa5 having a slope (instantaneous rate of change) of 0 in the first differential profile (Q'1), and divide the first differential profile (Q'1) into a plurality of sections Sa1 to Sa5 corresponding to the peak points Pa1 to Pa5, respectively. At this time, the capacity calculating unit 110 may divide the first differential profile (Q'1) into a plurality of sections Sa1 to Sa5 based on the valley points adjacent to the peak points Pa1 to Pa5.

Next, the capacity calculating unit 110 may select a section having a high correlation with the positive electrode capacity and a low correlation with the negative electrode capacity among the plurality of sections Sa1 to Sa5. For example, the capacity calculating unit 110 may select the fifth section Sa5 that corresponds to the high voltage section among the plurality of sections Sa1 to Sa5.

Then, the capacity calculating unit 110 may calculate the area between the voltage axis (horizontal axis) and the 5th section Sa5, and calculate the positive electrode capacity value of the target battery based on the calculated area. In this case, the capacity calculating unit 110 may consider the capacity value of the positive electrode corresponding to the area of the 5th section Sa5 calculated at the BOL period as being the same as the reference capacity value of the positive electrode determined during the design of the target battery.

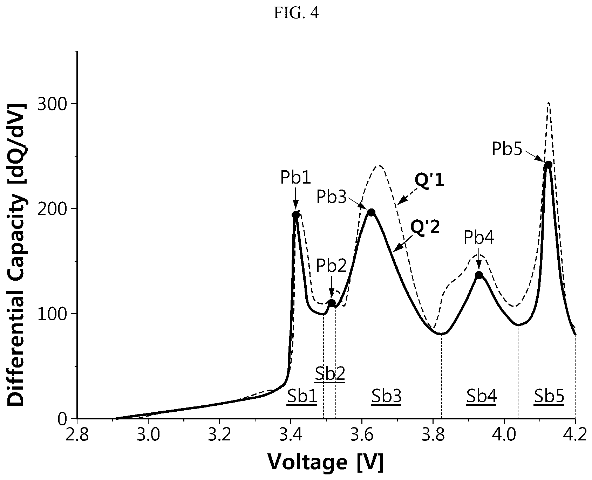

FIG. 4 shows the first differential profile (Q'2) corresponding to the 200th charge and discharge cycle of the target battery.

As illustrated in FIG. 4, the capacity calculating unit 110 may generate a first differential profile (Q'2) representing a correspondence relationship between the differential capacity obtained by differentiating the capacity of the target battery with respect to the voltage of the target battery and the voltage of the target battery, based on the battery profile BP generated in the 200th charge and discharge cycle of the target battery. Since the battery gradually degrades as the charge and discharge are repeated, the first differential profile (Q'2) corresponding to the 200th charge and discharge cycle becomes different from the first differential profile (Q'1) corresponding to the BOL period.

Then, the capacity calculating unit 110 may select a partial section from the entire section of the first differential profile (Q'2), calculate the area between the voltage axis (horizontal axis) representing the voltage of the first differential profile (Q'2) and the partial section, and calculate the positive electrode capacity value of the target battery based on the calculated area.

To this end, the capacity calculating unit 110 may select peak points Pb1 to Pb5 having a slope (instantaneous rate of change) of 0 in the first differential profile (Q'2), and divide the first differential profile (Q'2) into a plurality of sections Sb1 to Sb5 corresponding to the peak points Pb1 to Pb5, respectively. At this time, the capacity calculating unit 110 may divide the first differential profile (Q'2) into a plurality of sections Sb1 to Sb5 based on the valley points adjacent to the peak points Pb1 to Pb5.

Then, as described above, the capacity calculating unit 110 may select the fifth section Sb5 corresponding to the high voltage section among the plurality of sections Sb1 to Sb5.

Then, the capacity calculating unit 110 may calculate the area between the voltage axis (horizontal axis) and the 5th section Sb5, and calculate the positive electrode capacity value of the target battery based on the calculated area. In this case, the capacity calculating unit 110 may calculate the positive electrode capacity value of the target battery by comparing the area of the 5th section Sa5 calculated at the BOL period and the area of the 5th section Sb5 calculated at the 200th charge and discharge cycle. For example, the positive electrode capacity value of the target battery corresponding to the 200th charge and discharge cycle may be calculated as in the formula 2.

[Formula 2]

$$A_{BOL}:A_{200} = Cp_R:Cp_{200}$$

In the formula 2, $A_{BOL}$ is the area of the 5th section Sa5 calculated at the BOL period, $A_{200}$ is the area of the 5th section Sb5 calculated at the 200th charge and discharge cycle, $Cp_R$ is the reference capacity value of the positive electrode, and $Cp_{200}$ is the positive electrode capacity value corresponding to the 200th charge and discharge cycle.

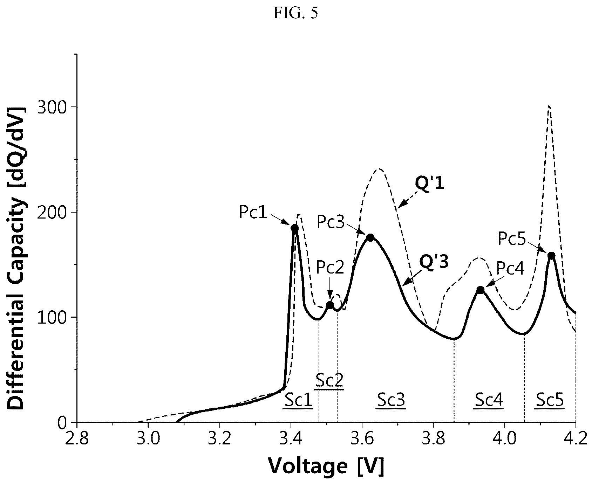

FIG. 5 shows the first differential profile (Q'3) corresponding to the 300th charge and discharge cycle of the target battery.

As illustrated in FIG. 5, the capacity calculating unit 110 may generate a first differential profile (Q'3) representing a correspondence relationship between the differential capacity obtained by differentiating the capacity of the target battery with respect to the voltage of the target battery and the voltage of the target battery, based on the battery profile BP generated in the 300th charge and discharge cycle of the target battery. Since the battery gradually degrades as the charge and discharge are repeated, the first differential profile (Q'3) corresponding to the 300th charge and discharge cycle is different from not only the first differential profile (Q'1) corresponding to the BOL period, but also the first differential profile (Q'2) corresponding to the 200th charge and discharge cycle.

Next, the capacity calculating unit 110 may select a partial section from the entire section of the first differential profile (Q'3), calculate the area between the voltage axis (horizontal axis) representing the voltage of the first differential profile (Q'3) and the partial section, and calculate the positive electrode capacity value of the target battery based on the calculated area.

To this end, the capacity calculating unit 110 may select peak points Pc1 to Pc5 having a slope (instantaneous rate of change) of 0 in the first differential profile (Q'3), and divide the first differential profile (Q'3) into a plurality of sections Sc1 to Sc5 corresponding to the peak points Pc1 to Pc5, respectively. At this time, the capacity calculating unit 110 may divide the first differential profile (Q'3) into a plurality of sections Sc1 to Sc5 based on the valley points adjacent to the peak points Pc1 to Pc5.

Then, as described above, the capacity calculating unit 110 may select the fifth section Sc5 corresponding to the high voltage section among the plurality of sections Sc1 to Sc5.

Then, the capacity calculating unit 110 may calculate the area between the voltage axis (horizontal axis) and the 5th section Sc5, and calculate the positive electrode capacity value of the target battery based on the calculated area. In this case, the capacity calculating unit 110 may calculate the positive electrode capacity value of the target battery by comparing the area of the 5th section Sa5 calculated at the BOL period and the area of the 5th section Sc5 calculated at the 300th charge and discharge cycle. For example, the positive electrode capacity value of the target battery corresponding to the 300th charge and discharge cycle may be calculated as in the formula 3.

[Formula 3]

$$A_{BOL}:A_{300} = Cp_R:Cp_{300}$$

In the formula 3, $A_{BOL}$ is the area of the 5th section Sa5 calculated at the BOL period, $A_{300}$ is the area of the 5th section Sc5 calculated at the 300th charge and discharge cycle, $Cp_R$ is the reference capacity value of the positive electrode, and $Cp_{300}$ is the positive electrode capacity value corresponding to the 300th charge and discharge cycle.

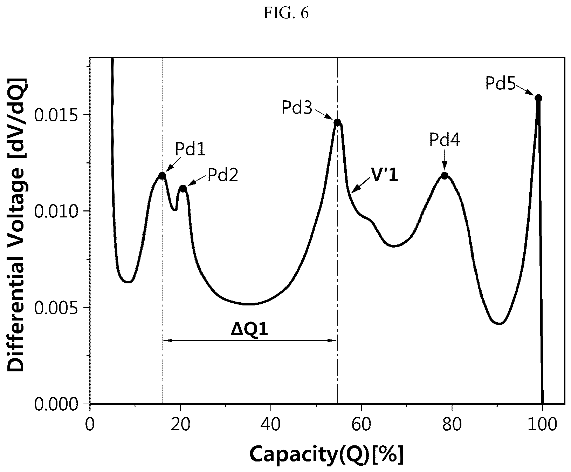

FIGS. 6 to 8 are drawings showing second differential profiles representing a correspondence relationship between the capacity and differential voltage of the battery in different charge and discharge cycles.

FIG. 6 shows the second differential profile (V'1) corresponding to the BOL (Beginning Of Life) period of the target battery.

As illustrated in FIG. 6, the capacity calculating unit 110 may generate a second differential profile (V'1) that represents a correspondence relationship between the differential voltage obtained by differentiating the voltage of the target battery with respect to the capacity of the target battery and the capacity of the target battery, based on the battery profile BP generated at the BOL (Beginning Of Life) period of the target battery, and calculate the negative electrode capacity value of the target battery using this second differential profile (V'1).

For example, the capacity calculating unit 110 may select two peaks among the peaks Pd1 to Pd5 appearing in the second differential profile (V'1) according to a predetermined selection criterion, calculate the capacity difference between these two peaks, and calculate the negative electrode capacity value based on the calculated capacity difference.

To this end, the capacity calculating unit 110 may select peaks Pd1 to Pd5 in the second differential profile (V'1) having a slope (instantaneous rate of change) of 0, and select two peaks among these peaks Pd1 to Pd5 that have a high correlation with the negative electrode capacity and a low correlation with the positive electrode capacity. For example, the capacity calculating unit 110 may select the first peak Pd1 and the third peak Pd3 located in the low capacity section among the peaks Pd1 to Pd5 of the second differential profile (V'1).

Then, the capacity calculating unit 110 may calculate the capacity difference (ΔQ1) between the first peak Pd1 and the third peak Pd3, and calculate the negative electrode capacity value of the target battery based on the calculated capacity difference (ΔQ1). In this case, the capacity calculating unit 110 may consider the capacity value of the negative electrode corresponding to the capacity difference (ΔQ1) calculated at the BOL time as being the same as the reference capacity value of the negative electrode determined during the design of the target battery.

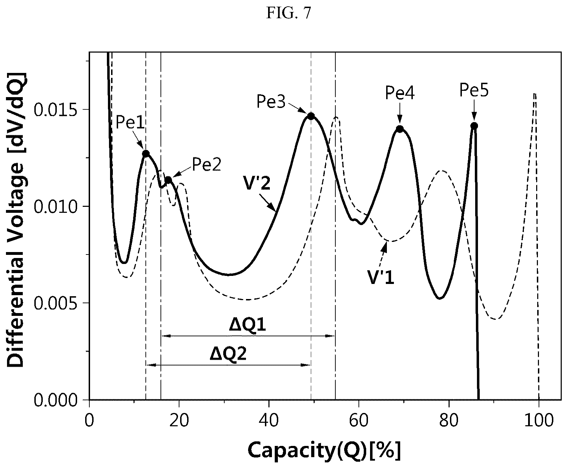

FIG. 7 shows the second differential profile (V'2) corresponding to the 200th charge and discharge cycle of the target battery.

As illustrated in FIG. 7, the capacity calculating unit 110 may generate a second differential profile (V'2) representing a correspondence relationship between the differential voltage obtained by differentiating the voltage of the target battery with respect to the capacity of the target battery and the capacity of the target battery, based on the battery profile BP generated in the 200th charge and discharge cycle of the target battery. Since the battery gradually degrades as the charge and discharge are repeated, the second differential profile (V'2) corresponding to the 200th charge and discharge cycle becomes different from the second differential profile (V'1) corresponding to the BOL period.

Then, the capacity calculating unit 110 may select two peaks among the peaks Pe1 to Pe5 appearing in the second differential profile (V'2) according to a predetermined selection criterion, calculate the capacity difference between these two peaks, and calculate the negative electrode capacity value of the target battery based on the calculated capacity difference.

For this purpose, the capacity calculating unit 110 may select peaks Pe1 to Pe5 having a slope (instantaneous rate of change) of 0 in the second differential profile (V'2), and as described above, select the first peak Pe1 and the third peak Pe3 located in the low capacity section among these peaks Pe1 to Pe5.

Then, the capacity calculating unit 110 may calculate the capacity difference ($\Delta$Q2) between the first peak Pe1 and the third peak Pe3, and calculate the negative electrode capacity value of the target battery based on the calculated capacity difference ($\Delta$Q2). In this case, the capacity calculating unit 110 may calculate the negative electrode capacity value of the target battery by comparing the capacity difference ($\Delta$Q1) calculated at the BOL period and the capacity difference ($\Delta$Q2) calculated at the 200th charge and discharge cycle. For example, the negative electrode capacity value of the target battery corresponding to the 200th charge and discharge cycle may be calculated as in the formula 4.

[Formula 4]

$$\Delta Q1 : \Delta Q2 = Cn_R : Cn_{200}$$

In the formula 4, $\Delta$Q1 is the capacity difference between the first peak Pd1 and the third peak Pd3 of the second differential profile (V'1) corresponding to the BOL period, $\Delta$Q2 is the capacity difference between the first peak Pe1 and the third peak Pe3 of the second differential profile (V'2) corresponding to the 200th charge and discharge cycle, $Cn_R$ is the reference capacity value of the negative electrode, and $Cn_{200}$ is the negative electrode capacity value corresponding to the 200th charge and discharge cycle.

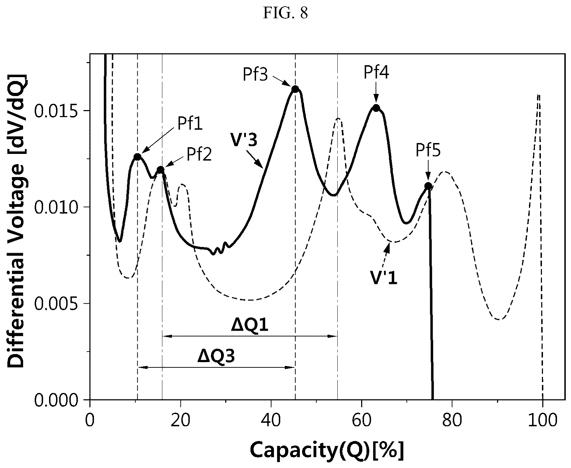

FIG. 8 shows the second differential profile (V'3) corresponding to the 300th charge and discharge cycle of the target battery.

As illustrated in FIG. 8, the capacity calculating unit 110 may generate a second differential profile (V'3) representing a correspondence relationship between the differential voltage obtained by differentiating the voltage of the target battery with respect to the capacity of the target battery and the capacity of the target battery, based on the battery profile BP generated in the 300th charge and discharge cycle of the target battery. Since the battery gradually degrades as the charge and discharge are repeated, the second differential profile (V'3) corresponding to the 300th charge and discharge cycle becomes different from not only the second differential profile (V'1) corresponding to the BOL period, but also the second differential profile (V'2) corresponding to the 200th charge and discharge cycle.

Then, the capacity calculating unit 110 may select two peaks among the peaks Pf1 to Pf5 appearing in the second differential profile (V'3) according to a predetermined selection criterion, calculate the capacity difference between these two peaks, and calculate the negative electrode capacity value of the target battery based on the calculated capacity difference.

For this purpose, the capacity calculating unit 110 may select peaks Pf1 to Pf5 having a slope (instantaneous rate of change) of 0 in the second differential profile (V'3), and as described above, select the first peak Pf1 and the third peak Pf3 located in the low capacity section among these peaks Pf1 to Pf5.

Then, the capacity calculating unit 110 may calculate the capacity difference ($\Delta$Q3) between the first peak Pf1 and the third peak Pf3, and calculate the negative electrode capacity value of the target battery based on the calculated capacity difference ($\Delta$Q3). In this case, the capacity calculating unit 110 may calculate the negative electrode capacity value of the target battery by comparing the capacity difference ($\Delta$Q1) calculated at the BOL period and the capacity difference ($\Delta$Q3) calculated at the 300th charge and discharge cycle. For example, the negative electrode capacity value of the target battery corresponding to the 300th charge and discharge cycle may be calculated as in the formula 5.

[Formula 5]

$$\Delta Q1 : \Delta Q3 = Cn_R : Cn_{300}$$

In the formula 4, $\Delta$Q1 is the capacity difference between the first peak Pd1 and the third peak Pd3 of the second differential profile (V'1) corresponding to the BOL period, $\Delta$Q3 is the capacity difference between the first peak Pf1 and the third peak Pf3 of the second differential profile (V'3) corresponding to the 300th charge and discharge cycle, $Cn_R$ is the reference capacity value of the negative electrode, and $Cn_{300}$ is the negative electrode capacity value corresponding to the 300th charge and discharge cycle.

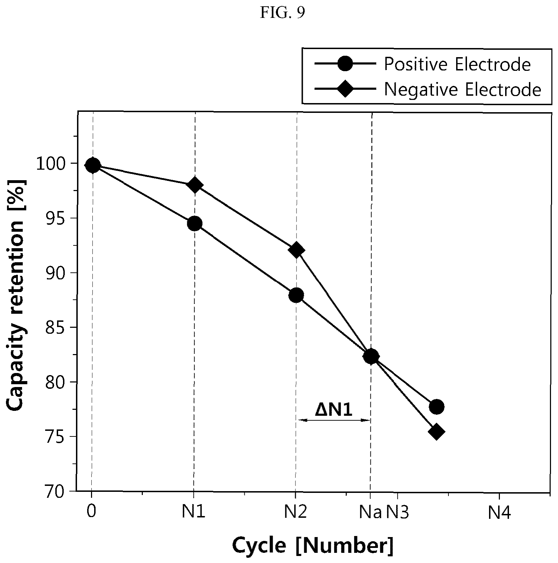

FIG. 9 is a drawing showing a first graph representing a trend of capacity decrease for each electrode of a battery with constant charge and discharge conditions.

As shown in FIG. 9, the positive electrode and negative electrode of the battery degrade as the number of charge and discharge cycles increases, and the available capacity gradually decreases.

Even though the degradation rate of the negative electrode becomes faster than that of the positive electrode after the N2 cycle, if the existing battery charge and discharge conditions are maintained constant, the degradation rate of the negative electrode becomes faster due to side reactions occurring in the battery. As a result, the period ($\Delta$N1) from the point in time (N2) at which the negative electrode degradation rate becomes faster than the positive electrode degradation rate to the EOL (End of Life) point (Na) of the battery at which the use of the battery must be discontinued becomes shorter.

Therefore, the apparatus for diagnosing a battery according to an embodiment of the present disclosure may monitor the degradation rate of the battery for each electrode, detect a point in time (N2) when the negative electrode degradation rate becomes faster than the positive electrode degradation rate, and alleviate the charge and discharge conditions of the battery from the detected point in time (N2), thereby ensuring the safety of the battery and extending the life of the battery.

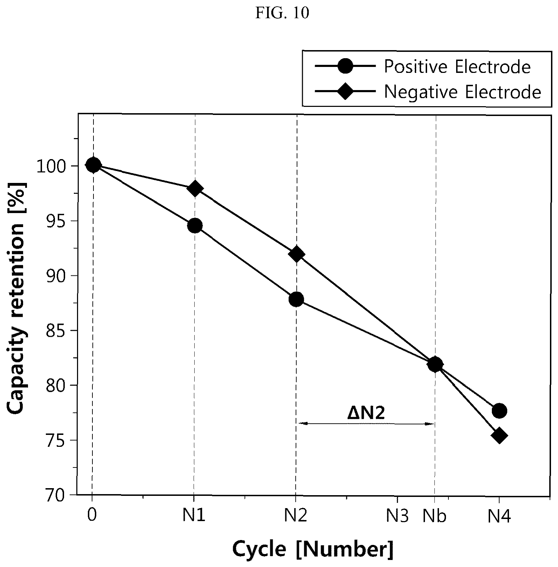

FIG. 10 is a drawing showing a second graph representing a trend of capacity decrease for each electrode of a battery with changed charge and discharge conditions according to the present disclosure.

As illustrated in FIG. 10, the apparatus for diagnosing a battery according to an embodiment of the present disclosure may monitor the degradation rate of the battery for each electrode, detect a point in time (N2) when the negative electrode degradation rate becomes faster than the positive electrode degradation rate, and alleviate the charge and discharge conditions of the battery from the detected point in time (N2), thereby slowing down the degradation rate of the battery, particularly the degradation rate of the negative electrode.

Therefore, according to the present disclosure, the period (ΔN2) from the point in time (N2) when the negative electrode degradation rate becomes faster than the positive electrode degradation rate to the EOL point (Nb) of the battery at which the use of the battery must be discontinued becomes longer.

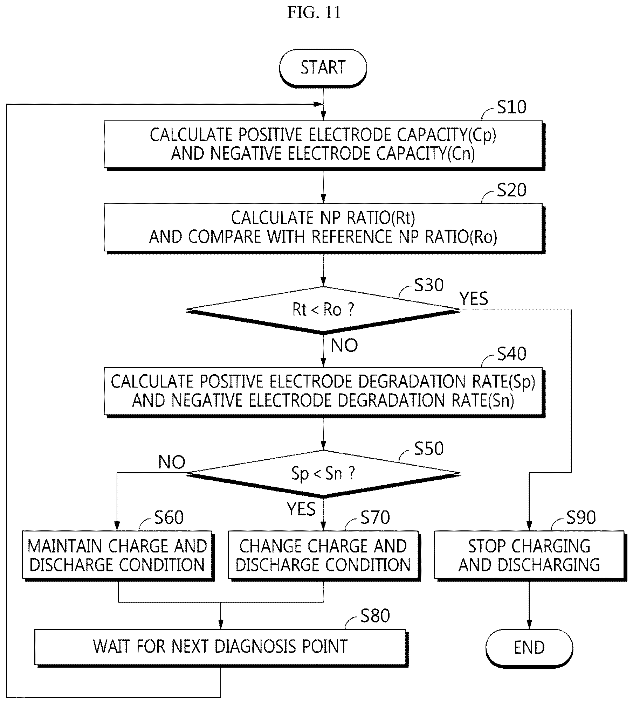

FIG. 11 is a flow chart showing a method for diagnosing a battery according to an embodiment of the present disclosure.

The method for diagnosing a battery according to the present disclosure is a method for diagnosing the state of a battery capable of repeated charging and discharging using a processor. In addition, the battery to be diagnosed by the method for diagnosing a battery according to the present disclosure (hereinafter, "target battery") may be a battery cell corresponding to a basic unit of charging and discharging, a battery module in which a plurality of battery cells are connected in series and/or in parallel, or a battery pack in which a plurality of battery cells or a plurality of battery modules are connected in series and/or in parallel.

According to an embodiment of the present disclosure, the processor calculates a positive electrode capacity value and a negative electrode capacity value, which represent current capacities of the positive electrode and the negative electrode of the target battery, respectively, for each predetermined number of charge and discharge cycles of the target battery.

Next, the processor calculates the positive electrode degradation rate and the negative electrode degradation rate of the target battery based on the calculated positive electrode capacity values and negative electrode capacity values.

Then, the processor diagnoses the state of the target battery by referring to the comparison result of the calculated positive electrode degradation rate and negative electrode degradation rate. If the comparison result confirms that the negative electrode degradation rate is faster than the positive electrode degradation rate, the processor may diagnose the state of the target battery as an abnormal state that requires a change in the charge condition or discharge condition of the target battery or discontinuation of use.

For example, as illustrated in FIG. 11, the processor may calculate a positive electrode capacity value (Cp) and a negative electrode capacity value (Cn), which represent the current capacities of the positive electrode and the negative electrode of the target battery, respectively, for each predetermined number of charge and discharge cycles of the target battery (S10).

To this end, before calculating the positive electrode capacity value (Cp) and the negative electrode capacity value (Cn) of the target battery, the processor may generate a battery profile that represents a correspondence relationship between the capacity and voltage of the target battery that change while the target battery is being charged or discharged, and calculate the positive electrode capacity value and the negative electrode capacity value of the target battery based on this battery profile, respectively.

In this case, the processor may obtain the positive electrode profile and the negative electrode profile of the target battery from the battery profile of the target battery using a predetermined simulation program as described in relation to FIG. 2. That is, the processor may obtain the positive electrode profile and the negative electrode profile of the target battery through a simulation program that selects a positive electrode profile and a negative electrode profile that generate a profile that is identical to or most similar to the battery profile of the target battery through a combination of various types of positive electrode profiles and negative electrode profiles. Then, the processor may calculate the positive electrode capacity value and the negative electrode capacity value of the target battery at the diagnosis point based on the obtained positive electrode profile and negative electrode profile.

In another embodiment, the processor may also calculate a positive electrode capacity value and a negative electrode capacity value of the target battery based on a differential profile obtained by differentiating the battery profile of the target battery with respect to voltage or capacity, as described with respect to FIGS. 3 to 8.

Then, before calculating the positive electrode degradation rate and the negative electrode degradation rate of the target battery, the processor may calculate the NP ratio (Rt) of the target battery corresponding to the diagnosis point using the positive electrode capacity value and the negative electrode capacity value of the target battery calculated at the diagnosis point of the target battery, and compare the calculated NP ratio (Rt) with the reference NP ratio (Ro) to primarily diagnose the state of the target battery (S20).

At this time, the NP ratio (Rt) of the target battery may be calculated as in the formula 1. In addition, the reference NP ratio (Ro) may be an NP ratio obtained by adding or subtracting a predetermined margin value to/from the NP ratio of the target battery calculated at the BOL time of the target battery, or an NP ratio determined in advance according to the components and amounts of the positive electrode active material and the negative electrode active material of the target battery.

As a result of comparing the NP ratio (Rt) of the target battery with the reference NP ratio (Ro), if the NP ratio (Rt) of the target battery is not smaller than the reference NP ratio (Ro) (S30), the processor may calculate the positive electrode degradation rate and the negative electrode degradation rate of the target battery, respectively, based on the positive electrode capacity values and the negative electrode capacity values calculated up to the diagnosis point (S40). For example, the processor may calculate the positive electrode degradation rate (Sp) and the negative electrode degradation rate (Sn) of the target battery, based on the positive electrode capacity decrease amount and the negative electrode capacity decrease amount of the target battery that are generated at each charge and discharge cycle of the target battery.

Next, the processor may diagnose the state of the target battery by comparing the positive electrode degradation rate (Sp) and the negative electrode degradation rate (Sn) of the target battery (S50).

For example, if the negative electrode degradation rate (Sn) is not faster than the positive electrode degradation rate (Sp), the processor may diagnose the state of the target battery as a normal state that does not require a change in the charge condition or discharge condition of the target battery. In this case, the processor may maintain the charge and discharge condition of the target battery (S60).

On the other hand, if the negative electrode degradation rate (Sn) is faster than the positive electrode degradation rate (Sp), the processor may diagnose the state of the target battery as a first abnormal state that requires a change in the charge condition or discharge condition of the target battery. In this case, the processor may alleviate the burden on the target battery by changing the charge condition or discharge condition of the target battery (S70).

That is, if the NP ratio (Rt) of the target battery is not smaller than the reference NP ratio (Ro) and the negative electrode degradation rate (Sn) of the target battery is not faster than the positive electrode degradation rate (Sp), the processor may diagnose the state of the target battery as a normal state that does not require a change in the charge condition or discharge condition of the target battery.

On the other hand, if the NP ratio (Rt) of the target battery is not smaller than the reference NP ratio (Ro), but the negative electrode degradation rate (Sn) of the target battery is faster than the positive electrode degradation rate (Sp), the processor may diagnose the state of the target battery as a first abnormal state that requires a change in the charge condition or discharge condition of the target battery.

For example, if the state of the target battery is diagnosed as the first abnormal state, the processor may control the charger or discharger to lower the current rate for charging or discharging the target battery or lower the full charge voltage of the target battery. In addition, the processor may control a cooling device such as a heat sink to lower the temperature of the target battery.

Then, the processor waits until the next diagnosis time, and when the next diagnosis time arrives, the processor may repeat the above-described processes (S10 to S70) (S80).

Meanwhile, at step S30, if the NP ratio (Rt) of the target battery is smaller than the reference NP ratio (Ro) as a result of comparing the NP ratio (Rt) of the target battery with the reference NP ratio (Ro) (S30), the processor may diagnose the state of the target battery as a second abnormal state that requires discontinuation of use of the battery. In this case, the processor may stop charging and discharging of the target battery (S90).

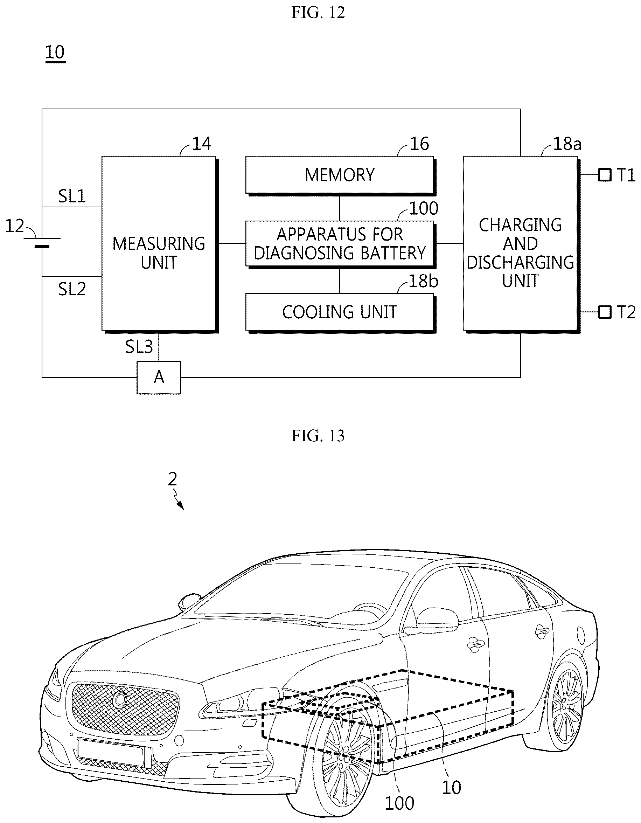

FIG. 12 is a drawing showing a battery pack 10 according to an embodiment of the present disclosure.

As illustrated in FIG. 12, the battery pack 10 includes a battery 12 capable of repeated charge and discharge, and the apparatus 100 for diagnosing a battery according to the present disclosure. In an embodiment, the battery pack 10 may optionally further include a measuring unit 14, a charging and discharging unit 18a, and a cooling unit 18b.

The measuring unit 14 may be configured to measure voltage and/or current of battery 12. For this purpose, the measuring unit 14 may include a voltage sensor 14a and a current sensor 14b as described with respect to FIG. 1. The measuring unit 14 may measure the voltage of the battery 12 via the first sensing line SL1 and the second sensing line SL2. Additionally, the measuring unit 14 may measure the current of the battery B via the third sensing line SL3 connected to the current measurement circuit A. The current measurement circuit A may include a shunt resistor.

In an embodiment, the measuring unit 14 may be configured to further measure the temperature of the battery 12. To this end, the measuring unit 14 may further include a temperature sensor 14c as described with respect to FIG. 1.

The apparatus 100 for diagnosing a battery according to an embodiment of the present disclosure may generate a battery profile as described with respect to FIG. 2 using the voltage information and current information of the battery 12 obtained from the measuring unit 14.

The charging and discharging unit 18a may be configured to charge and/or discharge the battery 12. To this end, the charging and discharging unit 18a may include a charger for charging the battery 12, a discharger for discharging the battery 12, at least one switch for electrically connecting the battery 12 to terminals T1, T2 of the battery pack 10, etc.

The apparatus 100 for diagnosing a battery according to an embodiment of the present disclosure may control the charging and discharging unit 18a to set charge and discharge conditions of the battery 12 or change the set charge and discharge conditions.

The cooling unit 18b may be configured to cool the battery 12. To this end, the cooling unit 18b may include a heat sink that absorbs heat from the battery 12 and releases heat to the outside.

The apparatus 100 for diagnosing a battery according to an embodiment of the present disclosure may control the temperature of the battery 12 by controlling the cooling unit 18b.

FIG. 13 is a drawing showing a vehicle according to an embodiment of the present disclosure.

As illustrated in FIG. 13, the vehicle 2 may include a battery pack 10 that provides electrical energy necessary for the operation of the vehicle and the apparatus 100 for diagnosing a battery according to the present disclosure.

In this case, the apparatus 100 for diagnosing a battery may be configured to interact with an ECU (Electronic Control Unit) that controls the operation of the vehicle 2 or a BMS (Battery Management System) of the battery pack 10.

For reference, the apparatus 100 for diagnosing a battery according to the present disclosure may be applied to various electrical devices or electrical systems other than vehicles, as well as to ESS (Energy Storage System).

As described above, the apparatus for diagnosing a battery according to the present disclosure calculates a positive electrode capacity value and a negative electrode capacity value of the battery for each predetermined number of charge and discharge cycles, and calculates a positive electrode degradation rate and a negative electrode degradation rate of the battery based on the calculated positive electrode capacity values and the calculated negative electrode capacity values, thereby enabling the degradation rate of the battery to be monitored for each electrode, and the point in time when a change in the charge and discharge condition of the battery is required may be accurately determined by referring to the degradation rate of each electrode.

Also, in an embodiment, the apparatus for diagnosing a battery diagnoses the state of the battery by referring to the comparison result of comparing the positive electrode degradation rate and the negative electrode degradation rate of the battery, thereby facilitating charge and discharge management of the battery, which may cause rapid performance degradation, shortened lifespan, or separator damage when a difference in degradation rate occurs between the positive electrode and the negative electrode, and ensuring the safety of the battery.

Also, in an embodiment, the apparatus for diagnosing a battery diagnoses the state of the battery based on the NP ratio and the degradation rate of each electrode, thereby determining the point in time of a change in the charge condition or discharge condition applied to the battery, thereby improving the safety of the battery and extending the life of the battery.

Furthermore, the embodiments according to the present disclosure may solve various technical problems other than those mentioned in this specification in the corresponding technical field as well as in related technical fields.

The present disclosure has been described with reference to specific embodiments. However, those skilled in the art will clearly understand that various modified embodiments can be implemented within the technical scope of the present disclosure. Therefore, the embodiments disclosed above should be considered from an illustrative rather than a restrictive perspective. In other words, the true technical scope of the present disclosure is indicated by the claims, and all differences within the scope equivalent thereto should be interpreted as being included in the present disclosure.

[Explanation of reference signs]

    2: vehicle
    10: battery pack
    100: apparatus for diagnosing a battery
    110: capacity calculating unit
    120: degradation rate calculating unit
    122: NP ratio calculating unit
    130: diagnosing unit
    140: charge and discharge adjusting unit

**Claims**

1.  An apparatus for diagnosing a battery, which diagnoses a state of a battery capable of repeated charging and discharging, the apparatus for diagnosing a battery comprising:

        a capacity calculating unit configured to calculate a positive electrode capacity value and a negative electrode capacity value of the battery, respectively, for each predetermined number of charge and discharge cycles;
        a degradation rate calculating unit configured to calculate a positive electrode degradation rate and a negative electrode degradation rate of the battery, respectively, based on the positive electrode capacity values and the negative electrode capacity values calculated by the capacity calculating unit; and
        a diagnosing unit configured to diagnose a state of the battery by referring to a comparison result of comparing the positive electrode degradation rate and the negative electrode degradation rate.

2. The apparatus for diagnosing a battery according to claim 1,
   wherein the capacity calculating unit is configured to generate a battery profile representing a correspondence relationship between capacity and voltage of the battery that changes while the battery is being charged or discharged, before calculating the positive electrode capacity value and the negative electrode capacity value, and to calculate the positive electrode capacity value and the negative electrode capacity value, respectively, based on the battery profile.

3. The apparatus for diagnosing a battery according to claim 2,
   wherein the capacity calculating unit is configured to generate a first differential profile representing a correspondence relationship between a differential capacity, which is obtained by differentiating the capacity of the battery with respect to the voltage of the battery, and the voltage of the battery, based on the battery profile, and to calculate the positive electrode capacity value using the first differential profile.

4. The apparatus for diagnosing a battery according to claim 3,
   wherein the capacity calculating unit is configured to select a partial section from an entire section of the first differential profile, calculate an area between a voltage axis representing the voltage of the first differential profile and the partial section, and calculate the positive electrode capacity value based on the calculated area.

5. The apparatus for diagnosing a battery according to claim 2,
   wherein the capacity calculating unit is configured to generate a second differential profile representing a correspondence relationship between a differential voltage, which is obtained by differentiating the voltage of the battery with respect to the capacity of the battery, and the capacity of the battery, based on the battery profile, and to calculate the negative electrode capacity value using the second differential profile.

6. The apparatus for diagnosing a battery according to claim 5,
   wherein the capacity calculating unit is configured to select two peaks among peaks appearing in the second differential profile according to a predetermined selection criterion, calculate a capacity difference between the two peaks, and calculate the negative electrode capacity value based on the calculated capacity difference.

7. The apparatus for diagnosing a battery according to claim 1,
   wherein the degradation rate calculating unit is configured to calculate the positive electrode degradation rate and the negative electrode degradation rate based on a positive electrode capacity decrease amount and a negative electrode capacity decrease amount of the battery that are generated at each charge and discharge cycle of the battery.

8. The apparatus for diagnosing a battery according to claim 1, further comprising:

   a NP ratio calculating unit for calculating a NP ratio of the battery by using the positive electrode capacity value and the negative electrode capacity value of the battery calculated at a diagnosis point of the battery,
   wherein the diagnosing unit is configured to determine the state of the battery by further referring to a comparison result of comparing the NP ratio with a predetermined reference NP ratio.

9. The apparatus for diagnosing a battery according to claim 8,
   wherein the diagnosing unit is configured to diagnose the state of the battery as a normal state that does not require a change in a charge condition or a discharge condition of the battery, when the NP ratio is not smaller than the reference NP ratio and the negative electrode degradation rate is not faster than the positive electrode degradation rate.

10. The apparatus for diagnosing a battery according to claim 8,
    wherein the diagnosing unit is configured to diagnose the state of the battery as a first abnormal state that requires a change in a charge condition or a discharge condition of the battery, when the NP ratio is not smaller than the reference NP ratio, but the negative electrode degradation rate is faster than the positive electrode degradation rate.

11. The apparatus for diagnosing a battery according to claim 8,
    wherein the diagnosing unit is configured to diagnose the state of the battery as a second abnormal state that requires discontinuation of use of the battery, when the NP ratio is smaller than the reference NP ratio.

12. The apparatus for diagnosing a battery according to claim 1,
    wherein the diagnosing unit is configured to diagnose the state of the battery as an abnormal state that requires a change in a charge condition or a discharge condition of the battery or discontinuation of use, when the negative electrode degradation rate is faster than the positive electrode degradation rate, and

wherein the apparatus for diagnosing a battery further comprises a charge and discharge adjusting unit configured to change the charge condition or the discharge condition of the battery or to stop charging and discharging of the battery, when the state of the battery is diagnosed as an abnormal state.

13. A battery pack comprising the apparatus for diagnosing a battery according to any one of claims 1 to 12.

14. A vehicle comprising the apparatus for diagnosing a battery according to any one of claims 1 to 12.

15. A method performed by a processor for diagnosing a battery capable of repeated charging and discharging, the method comprising:

calculating a positive electrode capacity value and a negative electrode capacity value of the battery, respectively, for each predetermined number of charge and discharge cycles;

calculating a positive electrode degradation rate and a negative electrode degradation rate of the battery based on the positive electrode capacity values and the negative electrode capacity values calculated; and

diagnosing a state of the battery by referring to a comparison result of comparing the positive electrode degradation rate and the negative electrode degradation rate.

FIG. 1

```
                                                    ┌─ 100
  ┌─────────────────────────────────────────────────┐
  │        APPARATUS FOR DIAGNOSING BATTERY          │
  │                                        ┌─ 110    │
  │  ┌─────────────────────────────────────────────┐ │
  │  │         CAPACITY CALCULATING UNIT           │ │
  │  └─────────────────────────────────────────────┘ │
  │          │                    │                   │
  │       ┌─ 120               ┌─ 122                 │
  │  ┌──────────────┐    ┌──────────────────┐         │
  │  │ DEGRADATION  │    │    NP RATIO       │         │
  │  │RATE CALCULAT-│    │ CALCULATING UNIT  │         │
  │  │   ING UNIT   │    │                   │         │
  │  └──────────────┘    └──────────────────┘         │
  │          │                    │                   │
  │          │                 ┌─ 130                 │
  │  ┌─────────────────────────────────────────────┐ │
  │  │              DIAGNOSING UNIT                │ │
  │  └─────────────────────────────────────────────┘ │
  │                    │                              │
  │                 ┌─ 140                            │
  │  ┌─────────────────────────────────────────────┐ │
  │  │    CHARGE AND DISCHARGE ADJUSTING UNIT      │ │
  │  └─────────────────────────────────────────────┘ │
  └──────────────────────────────────────────────────┘
```

| VOLTAGE SENSOR | CURRENT SENSOR | TEMPERATURE SENSOR | …. | MEMORY |
|---|---|---|---|---|
| 14a | 14b | 14c | | 16 |

FIG. 2

FIG. 3

FIG. 4

FIG. 5

FIG. 6

FIG. 7

FIG. 8

FIG. 9

FIG. 10

FIG. 11

```
                        ┌─────────┐
                        │  START  │
                        └────┬────┘
                             │
                             ▼                                    ⌐S10
        ┌────────────────────────────────────────────────┐
        │   CALCULATE POSITIVE ELECTRODE CAPACITY(Cp)     │
        │    AND NEGATIVE ELECTRODE CAPACITY(Cn)          │
        └────────────────────┬───────────────────────────┘
                             │                              ⌐S20
        ┌────────────────────▼───────────────────────────┐
        │          CALCULATE NP RATIO(Rt)                 │
        │   AND COMPARE WITH REFERENCE NP RATIO(Ro)       │
        └────────────────────┬───────────────────────────┘
                             │
                             ▼              ⌐S30     YES
                   ◇─────────────────────◇ ──────────────┐
                   ◇      Rt < Ro ?      ◇               │
                   ◇─────────────────────◇               │
                             │ NO                         │
                             ▼               ⌐S40        │
        ┌────────────────────────────────────────────┐  │
        │ CALCULATE POSITIVE ELECTRODE DEGRADATION    │  │
        │ RATE(Sp) AND NEGATIVE ELECTRODE             │  │
        │ DEGRADATION RATE(Sn)                        │  │
        └────────────────────┬───────────────────────┘  │
                             │                           │
              NO             ▼           ⌐S50            │
         ┌─────────◇─────────────────────◇              │
         │         ◇       Sp < Sn ?     ◇              │
         │         ◇─────────────────────◇              │
         │              │ YES                            │
         ▼ ⌐S60         ▼  ⌐S70              ⌐S90       ▼
   ┌──────────────┐ ┌──────────────┐    ┌──────────────┐
   │ MAINTAIN     │ │ CHANGE       │    │ STOP CHARGING│
   │ CHARGE AND   │ │ CHARGE AND   │    │ AND          │
   │ DISCHARGE    │ │ DISCHARGE    │    │ DISCHARGING  │
   │ CONDITION    │ │ CONDITION    │    └──────┬───────┘
   └──────┬───────┘ └──────┬───────┘           │
          │                │                    │
          └────────┬───────┘        ⌐S80        │
                   ▼                            ▼
        ┌──────────────────────────┐     ┌──────────┐
        │ WAIT FOR NEXT DIAGNOSIS  │     │   END    │
        │ POINT                    │     └──────────┘
        └──────────────────────────┘
```

FIG. 12

10

FIG. 13

## INTERNATIONAL SEARCH REPORT

| International application No. |
| --- |
| **PCT/KR2024/013167** |

### A. CLASSIFICATION OF SUBJECT MATTER

**G01R 31/392**(2019.01)i; **G01R 31/382**(2019.01)i; **G01R 31/385**(2019.01)i; **G01R 31/396**(2019.01)i; **G01R 19/165**(2006.01)i; **B60L 58/16**(2019.01)i; **H01M 10/0525**(2010.01)i; **H01M 10/48**(2006.01)i

According to International Patent Classification (IPC) or to both national classification and IPC

### B. FIELDS SEARCHED

Minimum documentation searched (classification system followed by classification symbols)

G01R 31/392(2019.01); B60R 16/04(2006.01); G01R 31/36(2006.01); H01M 10/42(2006.01); H01M 10/44(2006.01); H01M 10/48(2006.01); H02J 7/14(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 용량 산출부(capacity output unit), 퇴화 속도 산출부(degradation rate output unit), 진단부(diagnostic unit), 배터리 진단 장치(battery diagnostic device)

### C. DOCUMENTS CONSIDERED TO BE RELEVANT

| Category* | Citation of document, with indication, where appropriate, of the relevant passages | Relevant to claim No. |
| --- | --- | --- |
| A | JP 2017-054692 A (HITACHI LTD.) 16 March 2017 (2017-03-16)<br>See paragraphs [0023]-[0042]. | 1-15 |
| A | JP 2017-118780 A (MAZDA MOTOR CORP.) 29 June 2017 (2017-06-29)<br>See paragraphs [0008]-[0053] and claim 1. | 1-15 |
| A | KR 10-2020-0122111 A (LG CHEM, LTD.) 27 October 2020 (2020-10-27)<br>See paragraphs [0059]-[0133]. | 1-15 |
| A | JP 2017-227494 A (MAZDA MOTOR CORP.) 28 December 2017 (2017-12-28)<br>See paragraphs [0039]-[0040]. | 1-15 |
| A | KR 10-2021-0028476 A (SAMSUNG ELECTRONICS CO., LTD. et al.) 12 March 2021 (2021-03-12)<br>See paragraphs [0053]-[0067] and figure 7. | 1-15 |

☐ Further documents are listed in the continuation of Box C.  ☑ See patent family annex.

| | |
| --- | --- |
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **11 December 2024** | **11 December 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/013167**

| Patent document cited in search report | | | Publication date (day/month/year) | Patent family member(s) | | | Publication date (day/month/year) |
|---|---|---|---|---|---|---|---|
| JP | 2017-054692 | A | 16 March 2017 | JP | 6749080 | B2 | 02 September 2020 |
| | | | | US | 10564223 | B2 | 18 February 2020 |
| | | | | US | 2018-0246172 | A1 | 30 August 2018 |
| | | | | WO | 2017-043142 | A1 | 16 March 2017 |
| JP | 2017-118780 | A | 29 June 2017 | CN | 108475829 | A | 31 August 2018 |
| | | | | CN | 108475829 | B | 16 March 2021 |
| | | | | DE | 112016004024 | T5 | 17 May 2018 |
| | | | | JP | 6183446 | B2 | 23 August 2017 |
| | | | | US | 10930982 | B2 | 23 February 2021 |
| | | | | US | 2018-0261890 | A1 | 13 September 2018 |
| | | | | WO | 2017-110436 | A1 | 29 June 2017 |
| KR | 10-2020-0122111 | A | 27 October 2020 | CN | 112639498 | A | 09 April 2021 |
| | | | | CN | 112639498 | B | 08 March 2024 |
| | | | | EP | 3835802 | A1 | 16 June 2021 |
| | | | | EP | 3835802 | A4 | 15 December 2021 |
| | | | | EP | 3835802 | B1 | 14 February 2024 |
| | | | | ES | 2977315 | T3 | 21 August 2024 |
| | | | | HU | E065976 | T2 | 28 June 2024 |
| | | | | JP | 2021-533371 | A | 02 December 2021 |
| | | | | JP | 7124258 | B2 | 24 August 2022 |
| | | | | KR | 10-2684199 | B1 | 10 July 2024 |
| | | | | PL | 3835802 | T3 | 20 May 2024 |
| | | | | US | 11982719 | B2 | 14 May 2024 |
| | | | | US | 2022-0413058 | A1 | 29 December 2022 |
| | | | | WO | 2020-213905 | A1 | 22 October 2020 |
| JP | 2017-227494 | A | 28 December 2017 | JP | 6311746 | B2 | 18 April 2018 |
| KR | 10-2021-0028476 | A | 12 March 2021 | CN | 112448055 | A | 05 March 2021 |
| | | | | EP | 3790153 | A1 | 10 March 2021 |
| | | | | JP | 2021-040476 | A | 11 March 2021 |
| | | | | US | 12081058 | B2 | 03 September 2024 |
| | | | | US | 2021-0066945 | A1 | 04 March 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230136849
- JP 2009252381 A